# EUROPÄISCHE PATENTSCHRIFT

(11) **EP 2 502 343 B1**
(45) Veröffentlichungstag und Bekanntmachung des Hinweises auf die Patenterteilung: **25.06.2014**
(21) Anmeldenummer: 10776600.8
(22) Anmeldetag: 18.10.2010
(51) Int. Cl.: H03F 1/02, H03F 3/189

(54) **VERSTÄRKERANORDNUNG MIT GESTEUERTER RÜCKFÜHRUNG VON VERLUSTLEISTUNG**
AMPLIFIER ASSEMBLY HAVING CONTROLLED RETURN OF POWER LOSS
SYSTÈME AMPLIFICATEUR À RÉTROACTION COMMANDÉE DE LA PUISSANCE PERDUE

(30) Priorität: 17.11.2009 DE 102009053622
(43) Veröffentlichungstag der Anmeldung: 26.09.2012
(73) Patentinhaber: Siemens Aktiengesellschaft, 80333 München (DE)
(72) Erfinder: HEID, Oliver, 91052 Erlangen (DE)
(86) Internationale Anmeldenummer: PCT/EP2010/065594
(87) Internationale Veröffentlichungsnummer: WO 2011/061025

(56) Entgegenhaltungen:
- EP-A1- 1 243 065
- CN-A- 1 874 133
- JP-A- 2005 287 140
- US-A- 4 399 499
- US-A- 6 133 788

## Beschreibung

Die vorliegende Erfindung betrifft eine Verstärkeranordnung für ein Anfangssignal, das eine Anfangsfrequenz aufweist,
- wobei die Verstärkeranordnung einen Eingangssignalermittler aufweist, dem das Anfangssignal zugeführt wird und der anhand des Anfangssignals ein erstes Eingangssignal und ein zweites Eingangssignal ermittelt,
- wobei der Eingangssignalermittler das erste Eingangssignal einem ersten Verstärker zuführt, der das erste Eingangssignal zu einem ersten Ausgangssignal verstärkt,
- wobei der Eingangssignalermittler das zweite Eingangssignal einem zweiten Verstärker zuführt, der das zweite Eingangssignal zu einem zweiten Ausgangssignal verstärkt,
- wobei die Ausgangssignale untereinander gleiche Amplituden und die Anfangsfrequenz aufweisen und deren Phasenversatz gegeneinander, bezogen auf die Anfangsfrequenz, vom Betrag der Amplitude des Anfangssignals abhängt,
- wobei die Verstärker ihre Ausgangssignale einem gemeinsamen Koppelelement zuführen, das anhand der Ausgangssignale ein Nutzsignal und ein Verlustsignal bildet,
- wobei das Koppelelement derart ausgebildet ist, dass
   - eine Gesamtleistung, die das Nutzsignal und das Verlustsignal zusammen aufweisen, unabhängig vom Phasenversatz der Ausgangssignale ist,
   - eine Teilleistung, die das Nutzsignal aufweist, maximal ist, wenn der Phasenversatz der Ausgangssignale einen vorbestimmten Wert aufweist, und
   - die Teilleistung, die das Nutzsignal aufweist, mit der Abweichung des Phasenversatzes der Ausgangssignale von dem vorbestimmten Wert abnimmt,
- wobei das Koppelelement das Nutzsignal einer Last zuführt und das Verlustsignal einer Gleichrichtereinrichtung zuführt,
- wobei die Gleichrichtereinrichtung das Verlustsignal gleichrichtet und das gleichgerichtete Verlustsignal einer Stromversorgungseinrichtung der Verstärkeranordnung zuführt.

Die vorliegende Erfindung betrifft weiterhin ein Betriebsverfahren für eine derartige Verstärkeranordnung.

Eine Verstärkeranordnung der eingangs genannten Art und auch ein Betriebsverfahren für eine derartige Verstärkeranordnung sind beispielsweise aus der US 6,133,788 A und aus der US 6,285,251 B1 bekannt.

Es ist bekannt, dass ein einzelner Verstärker seinen maximalen Wirkungsgrad nur dann erreicht, wenn er bei seinem maximalen gesättigten Ausgangsniveau (oder zumindest in dessen Nähe) betrieben wird. Um den maximalen Wirkungsgrad über einen relativ großen Leistungsbereich aufrecht erhalten zu können, werden daher Verstärkeranordnungen verwendet, die zwei Verstärker aufweisen. Die beiden Verstärker werden derart betrieben, dass sie beide bei ihrem maximalen gesättigten Ausgangsniveau arbeiten. Die Ausgangssignale werden mittels eines geeigneten Koppelelements zu einem Nutzsignal vereinigt. Die Amplitude des Nutzsignals wird dadurch eingestellt, dass der Phasenversatz der beiden Ausgangssignale entsprechend eingestellt wird. Als Koppelelement wird in der Regel ein Hybrid oder ein Ringkoppler verwendet.

Wenn der Phasenversatz der Ausgangssignale von Null verschieden ist, fällt zusätzlich zum Nutzsignal auch ein Verlustsignal an. Das Verlustsignal führt zu negativen Rückwirkungen auf die Verstärker. Zur Vermeidung derartiger Rückwirkungen kann beispielsweise ein Widerstand vorgesehen sein, der das Verlustsignal in Wärme umwandelt. Das Verwenden des Widerstands verbessert die Betriebsbedingungen (reduzierte Rückwirkungen auf die Verstärker, reduzierte Verzerrungen usw.) der Verstärkeranordnung. Der Widerstand führt aber zugleich - insbesondere bei großem Phasenversatz, d. h. geringer Teilleistung des Nutzsignals - zu einer verringerten Gesamteffizienz der Verstärkeranordnung.

Die genannten Verstärkeranordnungen werden unter anderem bei Mobilfunkgeräten eingesetzt. Sie werden auch bei anderen batteriegespeisten Geräten eingesetzt. Bei batteriegespeisten Geräten ist die Energieeffizienz von besonderer Bedeutung. Es ist daher bereits versucht worden, anstelle des Widerstands eine Gleichrichtereinrichtung zu verwenden, welche das Verlustsignal gleichrichtet und das gleichgerichtete Verlustsignal einer Stromversorgungseinrichtung der Verstärkeranordnung zuführt.

Im Stand der Technik wird die Gleichrichtereinrichtung mit ungesteuerten Gleichrichterelementen (= Dioden) aufgebaut. Bei Verwendung derartiger Gleichrichterelemente ist die Begrenzerwirkung der Gleichrichterelemente nicht beeinflussbar. Dadurch ist der effektive Widerstand der Gleichrichtereinrichtung modulationsabhängig, d. h. abhängig vom Phasenversatz der Ausgangssignale voneinander. Auf Grund der Veränderbarkeit des effektiven Widerstands der Gleichrichtereinrichtung ist die Gleichrichtereinrichtung nicht bei allen Phasenversätzen gut angepasst. Es kommt bei manchen Phasenversätzen zu Reflexionen in die Verstärker, die ihrerseits nichtlineare Verzerrungen und Effizienzminderungen zur Folge haben.

Die Aufgabe der vorliegenden Erfindung besteht darin, eine Verstärkeranordnung der eingangs genannten Art derart weiterzubilden und derart zu betreiben, dass Reflexionen in die Verstärker nach Möglichkeit vermieden werden.

Die Aufgabe wird durch eine Verstärkeranordnung mit den Merkmalen des Anspruchs 1 gelöst. Vorteilhafte Ausgestaltungen der erfindungsgemäßen Verstärkeranordnung sind Gegenstand der abhängigen Ansprüche 2 bis 4.

Die Aufgabe wird weiterhin durch ein Betriebsverfahren mit den Merkmalen des Anspruchs 5 gelöst. Eine vorteilhafte Ausgestaltung des erfindungsgemäßen Betriebsverfahrens ist Gegenstand des abhängigen Anspruchs 6.

Erfindungsgemäß ist vorgesehen, eine Verstärkeranordnung der eingangs genannten Art derart auszugestalten, dass die Gleichrichtereinrichtung als Gleichrichterelemente aktive Bauteile aufweist und dass die aktiven Bauteile synchron zur Anfangsfrequenz gesteuert werden.

Bei dem erfindungsgemäßen Betriebsverfahren ist vorgesehen, die Verstärkeranordnung entsprechend zu betreiben, also die als Gleichrichterelemente wirkenden aktiven Bauteile synchron zur Anfangsfrequenz zu steuern und dadurch das Verlustsignal gleich zu richten.

Auf Grund der Verwendung der synchron zur Anfangsfrequenz angesteuerten aktiven Bauelemente (kurz: eines Synchrongleichrichters) können die Sperr- und Leitzeiten der aktiven Bauelemente gesteuert werden. Dadurch kann die effektive Lastimpedanz für die Verlustleistung optimiert werden. Im Zusammenwirken mit dem Koppelelement und der Einstellung des Phasenversatzes kann dadurch erreicht werden, dass
- der Last das Nutzsignal mit der gewünschten Teilleistung zugeführt wird,
- beide Verstärker mit einer optimalen (insbesondere modulationsunabhängigen) Lastimpedanz arbeiten,
- Modulationsnichtlinearitäten, Verzerrungen und Rückwirkungen gering gehalten werden und
- dennoch eine hohe Gesamteffizienz erreicht wird.

Die aktiven Bauelemente können nach Bedarf ausgebildet sein. Bevorzugt handelt es sich um Feldeffekttransistoren, insbesondere um MOSFETs.

Zur Optimierung der Ansteuerung der aktiven Bauelemente kann insbesondere vorgesehen sein, dass einer Steuereinrichtung für die Gleichrichtereinrichtung der Phasenversatz der Ausgangssignale zugeführt wird und die Steuereinrichtung den Phasenversatz bei der Ermittlung von Steuersignalen für die aktiven Bauelemente berücksichtigt.

Weitere Vorteile und Einzelheiten ergeben sich aus der nachfolgenden Beschreibung eines Ausführungsbeispiels in Verbindung mit den Zeichnungen. Es zeigen in Prinzipdarstellung:
- FIG 1: ein Blockschaltbild einer Verstärkeranordnung,
- FIG 2: ein Zeigerdiagramm,
- FIG 3: eine Gleichrichtereinrichtung und
- FIG 4 und 5: Zeitdiagramme.

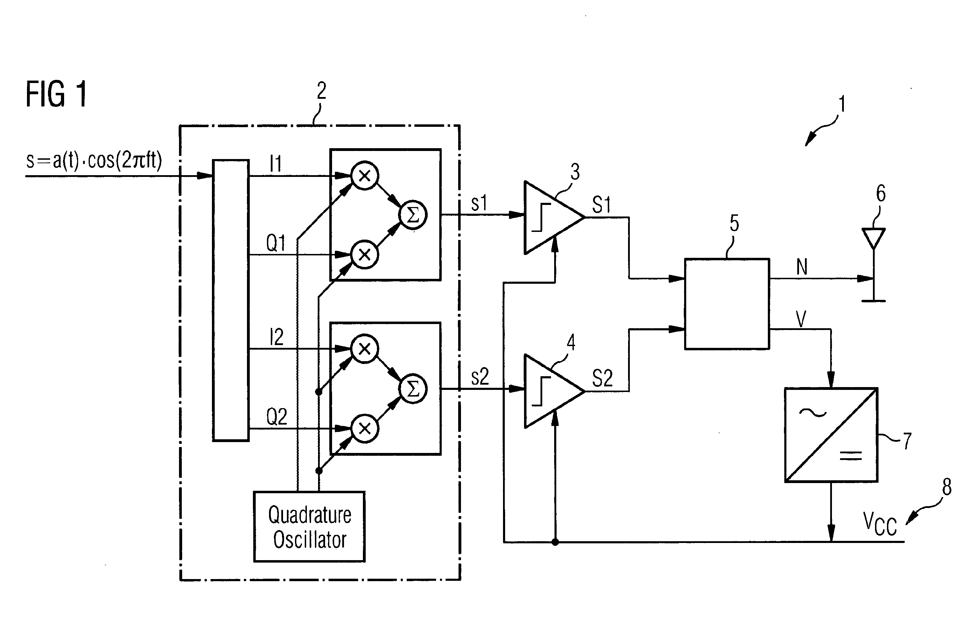

Gemäß FIG 1 weist eine Verstärkeranordnung 1 einen Eingangssignalermittler 2 auf. Dem Eingangssignalermittler 2 wird ein Anfangssignal s zugeführt. Das Anfangssignal s ist ein Wechselsignal, das eine Anfangsfrequenz f und eine Amplitude a aufweist. Der Begriff "Anfangsfrequenz" wurde hierbei so gewählt, um den Zusammenhang mit dem Anfangssignal s anzudeuten. Eine weitergehende Bedeutung kommt dem Begriff "Anfangsfrequenz" nicht zu. Oftmals handelt es sich bei dem Anfangssignal s um ein Signal in einem Frequenzbereich oberhalb von 20 MHz. In manchen Fällen weist das Anfangssignal s sogar eine Anfangsfrequenz f von über einem GHz auf. Teilweise werden sogar 10 GHz überschritten.

Der Eingangssignalermittler 2 ermittelt anhand des Anfangssignals s ein erstes Eingangssignal s1. Das erste Eingangssignal s1 weist die Anfangsfrequenz f auf. Falls ein erster Verstärker 3, der das erste Eingangssignal s1 zu einem ersten Ausgangssignal S1 verstärkt, Nichtlinearitäten aufweist, kann das erste Eingangssignal s1 vom Eingangssignalermittler 2 entsprechend vorverzerrt werden, so dass die Nichtlinearitäten des ersten Verstärkers 3 vorkompensiert werden.

Der Eingangssignalermittler 2 führt das Eingangssignal s1 dem ersten Verstärker 3 zu. Der erste Verstärker 3 verstärkt das erste Eingangssignal s1 zum ersten Ausgangssignal S1.

Der Eingangssignalermittler 2 ermittelt anhand des Anfangssignals s weiterhin ein zweites Eingangssignal s2. Das zweite Eingangssignal s2 weist ebenfalls die Anfangsfrequenz f auf. Falls ein zweiter Verstärker 4, der das zweite Eingangssignal s2 zu einem zweiten Ausgangssignal S2 verstärkt, Nichtlinearitäten aufweist, kann das zweite Eingangssignal s2 vom Eingangssignalermittler 2 entsprechend vorverzerrt werden, so dass die Nichtlinearitäten des zweiten Verstärkers 4 vorkompensiert werden.

Der Eingangssignalermittler 2 führt das zweite Eingangssignal s2 dem zweiten Verstärker 4 zu. Der zweite Verstärker 4 verstärkt das zweite Eingangssignal s2 zum zweiten Ausgangssignal S2.

Der Eingangssignalermittler 2 kann in bekannter Weise ausgebildet sein. Beispielsweise kann der Eingangssignalermittler 2 als digitaler Signalprozessor ausgebildet sein, der anhand des Anfangssignals s Quadratursignale ermittelt, anhand derer wiederum das erste Eingangssignal s1 und das zweite Eingangssignal s2 ermittelt werden. Aufbau und Wirkungsweise eines digitalen Signalprozessors und die Ermittlung von Quadratursignalen sind Fachleuten allgemein bekannt.

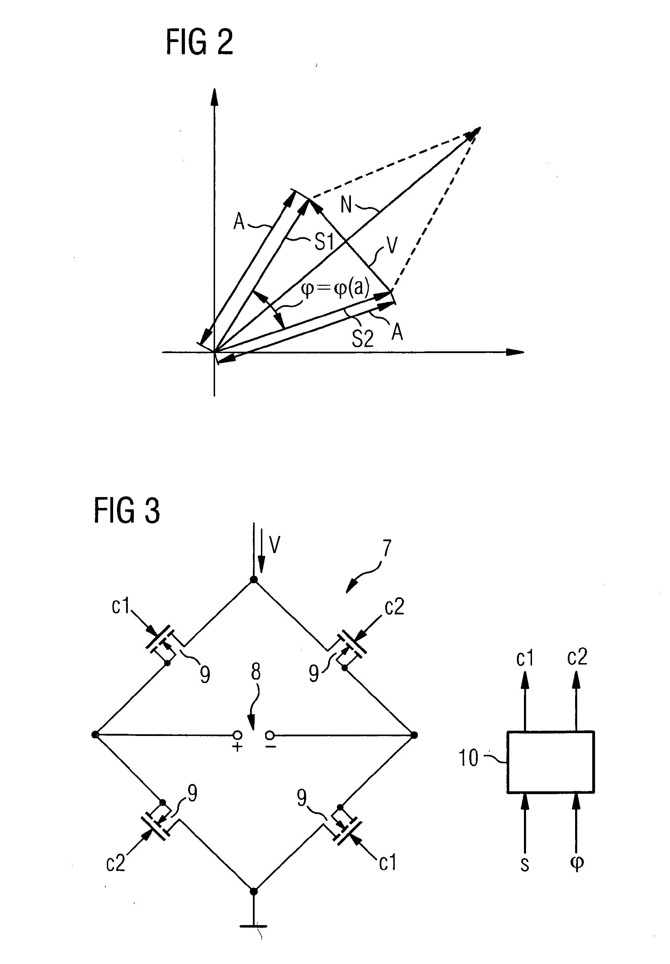

Das erste Ausgangssignal S1 und das zweite Ausgangssignal S2 weisen untereinander gemäß FIG 2 die gleiche Amplitude A auf. Die Amplitude A ist unabhängig von der Amplitude a des Anfangssignals s. Sie liegt im Bereich der Maximalamplitude der Verstärker 3, 4. Das erste Ausgangssignal S1 und das zweite Ausgangssignal S2 weisen jedoch - bezogen auf die Anfangsfrequenz f - einen Phasenversatz ϕ gegeneinander auf. Der Phasenversatz ϕ hängt von der Amplitude a des Anfangssignals s ab.

In der Regel sind die Verstärker 3, 4 gleich ausgebildet und werden gleichartig (insbesondere mit der gleichen Verstärkung) betrieben. In der Regel gelten die obigen Aussagen

(gleiche Amplitude, die nicht von der Amplitude a des Anfangssignals s abhängig ist, und Phasenversatz, der von der Amplitude a des Anfangssignal s abhängig ist) daher in analoger Weise auch für die den Verstärkern 3, 4 zugeführten Eingangssignale s1, s2.

Die Verstärker 3, 4 führen ihre Ausgangssignale S1, S2 gemäß FIG 1 einem gemeinsamen Koppelelement 5 zu. Das Koppelelement 5 bildet anhand der Ausgangssignale S1, S2 ein Nutzsignal N und ein Verlustsignal V. Das Koppelelement 5 kann beispielweise als Ringkoppler, als Richtkoppler, als 90°-Hybrid oder als 180°-Hybrid ausgebildet sein. In diesen Fällen bildet das Koppelelement 5 ein Summensignal und ein Differenzsignal der beiden Ausgangssignale S1, S2. Das Summensignal entspricht in diesem Fall dem Nutzsignal N, das Differenzsignal dem Verlustsignal V.

Das Koppelelement 5 ist ein verlustfrei arbeitendes Koppelelement 5. Es ist derart ausgebildet, dass es die ihm zugeführten Ausgangssignale S1, S2 verlustfrei in das Nutzsignal N und das Verlustsignal V umwandelt. Insbesondere ist daher eine Gesamtleistung, die das Nutzsignal N und das Verlustsignal V zusammen aufweisen, unabhängig vom Phasenversatz ϕ der Ausgangssignale S1, S2. Eine Amplitude (und damit verbunden auch eine Teilleistung), die das Nutzsignal N aufweist, ist hingegen gemäß FIG 2 vom Phasenversatz ϕ abhängig. Wenn der Phasenversatz ϕ gleich einem vorbestimmten Wert ist, ist die Teilleistung des Nutzsignals N maximal, die des Verlustsignals V minimal. Im optimalen Fall ist in diesem Fall die Teilleistung des Nutzsignals N gleich der Summe der Einzelleistungen der beiden Ausgangssignale S1, S2, die Teilleistung des Verlustsignals V gleich Null. Je weiter der Phasenversatz ϕ von dem vorbestimmten Wert abweicht, desto geringer ist die Teilleistung des Nutzsignals N. Die Teilleistung des Nutzsignals N nimmt also mit der Abweichung des Phasenversatzes ϕ von dem vorbestimmten Wert ab, in der Regel sogar streng monoton.

Der vorbestimmte Wert, bei dem die Teilleistung des Nutzsignals N maximal ist, hängt von der Art des Koppelelements 5 ab. Er kann beispielsweise 90° oder 180° betragen. In der Darstellung von FIG 2 wurde angenommen, dass der vorbestimmte Wert 0° ist.

Das Koppelelement 5 führt das Nutzsignal N einer Last 6 zu. Das Koppelelement 5 führt weiterhin das Verlustsignal V einer Gleichrichtereinrichtung 7 zu. Die Last 6 kann beispielsweise entsprechend der Darstellung von FIG 1 insbesondere eine Sendeantenne sein. Es sind jedoch auch andere Lasten denkbar. Im Falle einer Sendeantenne ist die Verstärkeranordnung 1 Bestandteil eines sogenannten "Outphasing-Senders". Die Gleichrichtereinrichtung 7 richtet das Verlustsignal V gleich. Das gleichgerichtete Verlustsignal führt die Gleichrichtereinrichtung 7 einer Stromversorgungseinrichtung 8 der Verstärkeranordnung 1 zu.

Gemäß FIG 3 ist die Gleichrichtereinrichtung 7 als Brückengleichrichter ausgebildet. Diese Ausgestaltung stellt den Regelfall der Gleichrichtereinrichtung 7 dar. Es sind jedoch auch andere Ausgestaltungen denkbar, insbesondere eine Ausgestaltung als einfacher Halbwellengleichrichter. Gemäß FIG 3 weist die Gleichrichtereihrichtung 7 als Gleichrichterelemente 9 aktive Bauelemente auf. Die aktiven Bauelemente 9 können nach Bedarf ausgebildet sein. Vorzugsweise sind die aktiven Bauelemente 9 als Feldeffekttransistoren ausgebildet, insbesondere als MOSFETs. Auch eine Ausgestaltung als IGBT ist jedoch möglich.

Allgemein ist es ausreichend, wenn pro Strompfad der Gleichrichtereinrichtung 7 mindestens eines der im jeweiligen Strompfad befindlichen Gleichrichterelemente 9 als aktives Bauelement 9 ausgebildet ist. Bei der Ausgestaltung der Gleichrichtereinrichtung 7 gemäß FIG 3 könnten also beispielsweise zwei der vier Gleichrichterelemente 9 als einfache, ungesteuerte Gleichrichterelemente (= Dioden) ausgebildet sein. Gemäß FIG 3 sind jedoch alle Gleichrichterelemente 9 als aktive Bauelemente ausgebildet.

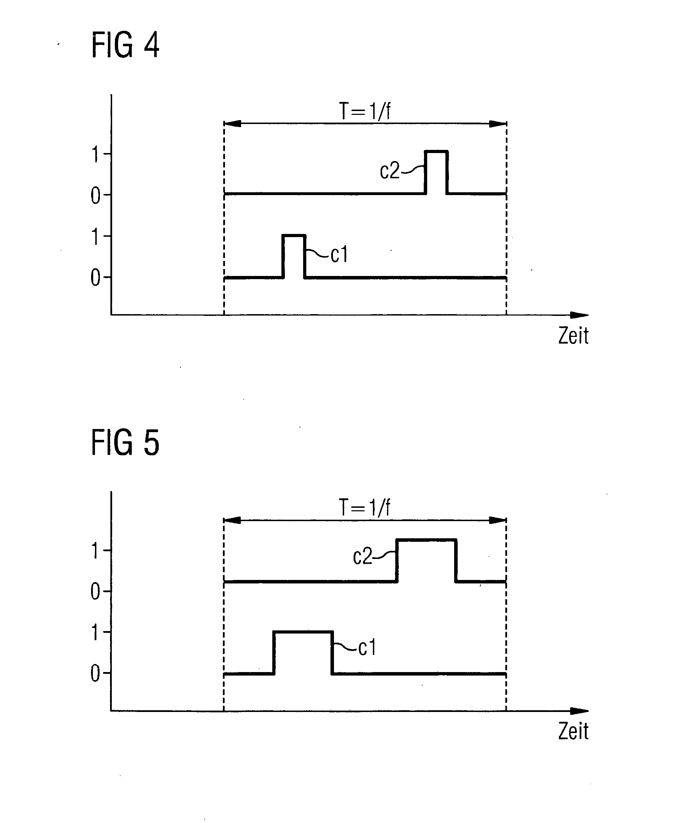

Die aktiven Bauelemente 9 werden gemäß den FIG 4 und 5 synchron zur Anfangsfrequenz f gesteuert. Dadurch richten sie das Verlustsignal V gleich.

Zur korrekten Ansteuerung der aktiven Bauelemente 9 wird einer Steuereinrichtung 10 für die Gleichrichtereinrichtung 7 - selbstverständlich - ein mit der Anfangsfrequenz f oszillie-, rendes Signal zugeführt, beispielsweise das Anfangssignal s oder ein korrespondierendes Taktsignal. Anhand dieses Signals ermittelt die Steuereinrichtung 10, welche Brückenzweige der Gleichrichtereinrichtung 7 jeweils leitend gesteuert werden dürfen und welche Brückenzweige gesperrt bleiben müssen. Vorzugsweise wird der Steuereinrichtung 10 weiterhin der Phasenversatz ϕ der Ausgangssignale S1, S2 zugeführt. In diesem Fall kann die Steuereinrichtung 10 den Phasenversatz ϕ bei der Ermittlung von Steuersignalen c1, c2 für die aktiven Bauelemente 9 berücksichtigen. Dies ist in den FIG 4 und 5 dadurch angedeutet, dass für den Phasenversatz ϕ bei der Darstellung von FIG 5 andere Sperr- und Leitzeiten der aktiven Bauelemente 9 eingezeichnet sind als für den Phasenversatz ϕ bei der Darstellung von FIG 4.

Die vorliegende Erfindung weist viele Vorteile auf. Insbesondere kann auf einfache Weise eine hohe Energieeffizienz erreicht werden, wobei dennoch nahezu keine Rückkopplungen auf die Verstärker 3, 4 auftreten. Dadurch ergibt sich insbesondere eine gute Linearität der Verstärker 3, 4.

Die erfindungsgemäße Verstärkeranordnung 1 ist für verschiedene Einsatzzwecke verwendbar. Bevorzugt wird die erfindungsgemäße Verstärkeranordnung 1 bei mobilen, batteriegespeisten Geräten verwendet, beispielsweise bei Mobilfunkgeräten einschließlich Mobiltelefonen. Auch eine Verwendung bei Hochleistungssendern ist möglich. Beispiele derartiger Hochleistungssender sind beispielsweise die Sendeverstärker für die Sendeantennen und die Gradientenspulen von Magnetresonanzanlagen.

Die obige Beschreibung dient ausschließlich der Erläuterung der vorliegenden Erfindung. Der Schutzumfang der vorliegenden Erfindung soll hingegen ausschließlich durch die beigefügten Ansprüche bestimmt sein.

### Bezugszeichenliste

- *1*: *Verstärkeranordnung*
- *2*: *Eingangssignalermittler*
- *3, 4*: *Verstärker*
- *5*: *Koppelelement*
- *6*: *Last*
- *7*: *Gleichrichtereinrichtung*
- *8*: *Stromversorgungseinrichtung*
- *9*: *Gleichrichterelementelaktive Bauelemente*
- *10*: *Steuereinrichtung*
- *a*, *A*: *Amplituden*
- *c1, c2*: *Steuersignale*
- *f*: *Anfangsfrequenz*
- *N*: *Nutzsignal*
- *s*: *Anfangssignal*
- *s1, s2*: *Eingangssignale*
- *S1, S2*: *Ausgangssignale*
- *V*: *Verlustsignal*
- *ϕ*: *Phasenversatz*

## Patentansprüche

1. Verstärkeranordnung für ein Anfangssignal (s), das eine Anfangsfrequenz (f) aufweist,
- wobei die Verstärkeranordnung einen Eingangssignalermittler (2) aufweist, dem das Anfangssignal (s) zugeführt wird und der anhand des Anfangssignals (s) ein erstes Eingangssignal (s1) und ein zweites Eingangssignal (s2) ermittelt,
- wobei der Eingangssignalermittler (2) das erste Eingangssignal (s1) einem ersten Verstärker (3) zuführt, der das erste Eingangssignal (s1) zu einem ersten Ausgangssignal (S1) verstärkt,
- wobei der Eingangssignalermittler (2) das zweite Eingangssignal (s2) einem zweiten Verstärker (4) zuführt, der das zweite Eingangssignal (s2) zu einem zweiten Ausgangssignal (S2) verstärkt,
- wobei die Ausgangssignale (S1, S2) untereinander gleiche Amplituden (A) und die Anfangsfrequenz (f) aufweisen und deren Phasenversatz (ϕ) gegeneinander, bezogen auf die Anfangsfrequenz (f), vom Betrag der Amplitude (a) des Anfangssignals (s) abhängt,
- wobei die Verstärker (3, 4) ihre Ausgangssignale (S1, S2) einem gemeinsamen Koppelelement (5) zuführen, das anhand der Ausgangssignale (S1, S2) ein Nutzsignal (N) und ein Verlustsignal (V) bildet,
- wobei das Koppelelement (5) derart ausgebildet ist, dass
- - eine Gesamtleistung, die das Nutzsignal (N) und das Verlustsignal (V) zusammen aufweisen, unabhängig vom Phasenversatz (ϕ) der Ausgangssignale (S1, S2) ist,
- - eine Teilleistung, die das Nutzsignal (N) aufweist, maximal ist, wenn der Phasenversatz (ϕ) der Ausgangssignale (S1, S2) einen vorbestimmten Wert aufweist, und
- - die Teilleistung, die das Nutzsignal (N) aufweist, mit der Abweichung des Phasenversatzes (ϕ) der Ausgangssignale (S1, S2) von dem vorbestimmten Wert abnimmt,
- wobei das Koppelelement (5) das Nutzsignal (N) einer Last (6) zuführt und das Verlustsignal (V) einer Gleichrichtereinrichtung (7) zuführt,
- wobei die Gleichrichtereinrichtung (7) das Verlustsignal (V) gleichrichtet und das gleichgerichtete Verlustsignal einer Stromversorgungseinrichtung (8) der Verstärkeranordnung zuführt,
**dadurch gekennzeichnet,**
**dass** die Gleichrichtereinrichtung (7) als Gleichrichterelemente (9) aktive Bauteile (9) aufweist und dass die aktiven Bauteile (9) synchron zur Anfangsfrequenz (f) gesteuert werden.

2. Verstärkeranordnung nach Anspruch 1,
**dadurch gekennzeichnet,**
**dass** die aktiven Bauelemente (9) als Feldeffekttransistoren ausgebildet sind.

3. Verstärkeranordnung nach Anspruch 2,
**dadurch gekennzeichnet,**
**dass** die Feldeffekttransistoren als MOSFETs ausgebildet sind.

4. Verstärkeranordnung nach Anspruch 1, 2 oder 3, **dadurch gekennzeichnet,**
**dass** einer Steuereinrichtung (10) für die Gleichrichtereinrichtung (7) der Phasenversatz (ϕ) der Ausgangssignale (S1, S2) zugeführt wird und dass die Steuereinrichtung (10) den Phasenversatz (ϕ) bei der Ermittlung von Steuersignalen (c1, c2) für die aktiven Bauelemente (9) berücksichtigt.

5. Betriebsverfahren für eine Verstärkeranordnung (1),
- wobei einem Eingangssignalermittler (2) der Verstärkeranordnung (1) ein Anfangssignal (s) zugeführt wird, das eine Anfangsfrequenz (f) aufweist,
- wobei der Eingangssignalermittler (2) anhand des Anfangssignals (s) ein erstes Eingangssignal (s1) und ein zweites Eingangssignal (s2) ermittelt,
- wobei der Eingangssignalermittler (2) das erste Eingangssignal (s1) einem ersten Verstärker (3) zuführt, der das erste Eingangssignal (s1) zu einem ersten Ausgangssignal (S1) verstärkt,
- wobei der Eingangssignalermittler (2) das zweite Eingangssignal (s2) einem zweiten Verstärker (4) zuführt, der das zweite Eingangssignal (s2) zu einem zweiten Ausgangssignal (S2) verstärkt,
- wobei die Ausgangssignale (S1, S2) untereinander gleiche Amplituden (A) und die Anfangsfrequenz (f) aufweisen und deren Phasenversatz (ϕ) gegeneinander, bezogen auf die Anfangsfrequenz (f), vom Betrag der Amplitude (a) des Anfangssignals (s) abhängt,
- wobei die Verstärker (3, 4) ihre Ausgangssignale (S1, S2) einem gemeinsamen Koppelelement (5) zuführen, das anhand der Ausgangssignale (S1, S2) ein Nutzsignal (N) und ein Verlustsignal (V) bildet,
- wobei eine Gesamtleistung, die das Nutzsignal (N) und das Verlustsignal (V) zusammen aufweisen, unabhängig vom Phasenversatz (ϕ) der Ausgangssignale (S1, S2) ist, eine Teilleistung, die das Nutzsignal (N) aufweist, maximal ist, wenn der Phasenversatz (ϕ) der Ausgangssignale (S1, S2) einen vorbestimmten Wert aufweist, und die Teilleistung, die das Nutzsignal (N) aufweist, mit der Abweichung des Phasenversatzes (ϕ) der Ausgangssignale (S1, S2) von dem vorbestimmten Wert abnimmt,
- wobei das Koppelelement (5) das Nutzsignal (N) einer Last (6) zuführt und das Verlustsignal (V) einer Gleichrichtereinrichtung (7) zuführt,
- wobei die Gleichrichtereinrichtung (7) das Verlustsignal (V) gleichrichtet und das gleichgerichtete Verlustsignal einer Stromversorgungseinrichtung (8) der Verstärkeranordnung (1) zuführt,
- wobei als Gleichrichterelemente (9) wirkende aktive Bauteile (9) der Gleichrichtereinrichtung (7) synchron zur Anfangsfrequenz (f) gesteuert werden und dadurch das Verlustsignal (V) gleichrichten.

6. Betriebsverfahren nach Anspruch 5,
**dadurch gekennzeichnet,**
**dass** einer Steuereinrichtung (10) für die Gleichrichtereinrichtung (7) der Phasenversatz (ϕ) der Ausgangssignale (S1, S2) zugeführt wird und dass die Steuereinrichtung (10) den Phasenversatz (ϕ) bei der Ermittlung von Steuersignalen (c1, c2) für die aktiven Bauelemente (9) berücksichtigt.

## Claims

1. Amplifier assembly for an initial signal (s) having an initial frequency (f),
- wherein the amplifier assembly has an input signal determiner (2), to which the initial signal (s) is fed and which determines a first input signal (s1) and a second input signal (s2) on the basis of the initial signal (s),
- wherein the input signal determiner (2) feeds the first input signal (s1) to a first amplifier (3), which amplifies the first input signal (s1) to form a first output signal (S1),
- wherein the input signal determiner (2) feeds the second input signal (s2) to a second amplifier (4), which amplifies the second input signal (s2) to form a second output signal (S2),
- wherein the output signals (S1, S2) have mutually identical amplitudes (A) and the initial frequency (f), and their phase offset (ϕ) with respect to one another, relative to the initial frequency (f), is dependent on the absolute value of the amplitude (a) of the initial signal (s),
- wherein the amplifiers (3, 4) feed their output signals (S1, S2) to a common coupling element (5), which forms a useful signal (N) and a loss signal (V) on the basis of the output signals (S1, S2),
- wherein the coupling element (5) is embodied in such a way that
- - a total power which the useful signal (N) and the loss signal (V) have together is independent of the phase offset (ϕ) of the output signals (S1, S2),
- - a partial power exhibited by the useful signal (N) is at a maximum if the phase offset (ϕ) of the output signals (S1, S2) has a predetermined value, and
- - the partial power exhibited by the useful signal (N) decreases with the deviation of the phase offset (ϕ) of the output signals (S1, S2) from the predetermined value,
- wherein the coupling element (5) feeds the useful signal (N) to a load (6) and feeds the loss signal (V) to a rectifier device (7),
- wherein the rectifier device (7) rectifies the loss signal (V) and feeds the rectified loss signal to a power supply device (8) of the amplifier assembly, **characterized**
**in that** the rectifier device (7) has active components (9) as rectifier elements (9), and in that the active components (9) are controlled synchronously with respect to the initial frequency (f).

2. Amplifier assembly according to Claim 1, **characterized**
**in that** the active components (9) are embodied as field effect transistors.

3. Amplifier assembly according to Claim 2, **characterized**
**in that** the field effect transistors are embodied as MOSFETs.

4. Amplifier assembly according to Claim 1, 2 or 3, **characterized**
**in that** the phase offset (ϕ) of the output signals (S1, S2) is fed to a control device (10) for the rectifier device (7), and in that the control device (10) takes account of the phase offset (ϕ) when determining control signals (c1, c2) for the active components (9).

5. Operating method for an amplifier assembly (1),
- wherein an initial signal (s) having an initial frequency (f) is fed to an input signal determiner (2) of the amplifier assembly (1),
- wherein the input signal determiner (2) determines a first input signal (s1) and a second input signal (s2) on the basis of the initial signal (s),
- wherein the input signal determiner (s) feeds the first input signal (s1) to a first amplifier (3), which amplifies the first input signal (s1) to form a first output signal (S1),
- wherein the input signal determiner (2) feeds the second input signal (s2) to a second amplifier (4), which amplifies the second input signal (s2) to form a second output signal (S2),
- wherein the output signals (S1, S2) have mutually identical amplitudes (A) and the initial frequency (f), and their phase offset (ϕ) with respect to one another, relative to the initial frequency (f), is dependent on the absolute value of the amplitude (a) of the initial signal (s),
- wherein the amplifiers (3, 4) feed their output signals (S1, S2) to a common coupling element (5), which forms a useful signal (N) and a loss signal (V) on the basis of the output signals (S1, S2),
- wherein a total power which the useful signal (N) and the loss signal (V) have together is independent of the phase offset (ϕ) of the output signals (S1, S2), a partial power exhibited by the useful signal (N) is at a maximum if the phase offset (ϕ) of the output signals (S1, S2) has a predetermined value, and the partial power exhibited by the useful signal (N) decreases with the deviation of the phase offset (ϕ) of the output signals (S1, S2) from the predetermined value,
- wherein the coupling element (5) feeds the useful signal (N) to a load (6) and feeds the loss signal (V) to a rectifier device (7),
- wherein the rectifier device (7) rectifies the loss signal (V) and feeds the rectified loss signal to a power supply device (8) of the amplifier assembly (1),
- wherein active components (9) of the rectifier device (7) which act as rectifier elements (9) are controlled synchronously with respect to the initial frequency (f) and thereby rectify the loss signal (V).

6. Operating method according to Claim 5,
**characterized**
**in that** the phase offset (ϕ) of the output signals (S1, S2) is fed to a control device (10) for the rectifier device (7), and in that the control device (10) takes account of the phase offset (ϕ) when determining control signals (c1, c2) for the active components (9).

## Revendications

1. Ensemble d'amplificateurs pour un signal initial (s) qui présente une fréquence initiale (f),
- l'ensemble d'amplificateurs comportant un déterminateur de signaux d'entrée (2) sur lequel est envoyé le signal initial (s) et qui détermine un premier signal d'entrée (s1) et un deuxième signal d'entrée (s2) à partir du signal initial (s),
- le déterminateur de signaux d'entrée (2) envoyant le premier signal d'entrée (s1) sur un premier amplificateur (3) qui amplifie le premier signal d'entrée (s1) pour donner un premier signal de sortie (S1),
- le déterminateur de signaux d'entrée (2) envoyant le deuxième signal d'entrée (s2) sur un deuxième amplificateur (4) qui amplifie le deuxième signal d'entrée (s2) pour donner un deuxième signal de sortie (S2),
- les signaux de sortie (S1, S2) présentant des amplitudes (A) identiques entre elles et la fréquence initiale (f), et leur décalage de phase (ϕ) l'un par rapport à l'autre, rapporté à la fréquence initiale (f), dépendant de la valeur absolue de l'amplitude (a) du signal initial (s),
- les amplificateurs (3, 4) envoyant leurs signaux de sortie (S1, S2) sur un élément de couplage commun (5) qui forme un signal utile (N) et un signal de perte (V) à partir des signaux de sortie (S1, S2),
- l'élément de couplage (5) étant conçu de manière telle que :
- - une puissance globale que présentent ensemble le signal utile (N) et le signal de perte (V) est indépendante du décalage de phase (ϕ) des signaux de sortie (S1, S2),
- - une puissance partielle du signal utile (N) est maximale lorsque le décalage de phase (ϕ) des signaux de sortie (S1, S2) présente une valeur prédéfinie et
- - la puissance partielle du signal utile (N) décroît avec l'écart du décalage de phase (ϕ) des signaux de sortie (S1, S2) par rapport à la valeur prédéfinie,
- l'élément de couplage (5) envoyant le signal utile (N) sur une charge (6) et le signal de perte (V) sur un dispositif redresseur (7),
- le dispositif redresseur (7) redressant le signal de perte (V) et envoyant le signal de perte redressé sur un dispositif d'alimentation électrique (8) de l'ensemble d'amplificateurs,
**caractérisé en ce que** le dispositif redresseur (7) comporte des composants (9) actifs en tant qu'éléments redresseurs et **en ce que** les composants actifs (9) sont commandés de manière synchrone avec la fréquence initiale (f).

2. Ensemble d'amplificateurs selon la revendication 1, **caractérisé en ce que** les composants actifs (9) se présentent sous la forme de transistors à effet de champ.

3. Ensemble d'amplificateurs selon la revendication 2, **caractérisé en ce que** les transistors à effet de champ se présentent sous la forme de transistors MOSFET.

4. Ensemble d'amplificateurs selon la revendication 1, 2 ou 3, **caractérisé en ce que** le décalage de phase (ϕ) des signaux de sortie (S1, S2) est envoyé sur un dispositif de commande (10) pour le dispositif redresseur (7) et **en ce que** le dispositif de commande (10) tient compte du décalage de phase (ϕ) lors de la détermination de signaux de commande (c1, c2) pour les composants actifs (9).

5. Procédé d'exploitation d'un ensemble d'amplificateurs (1),
- un signal initial (s) présentant une fréquence initiale (f) étant envoyé sur un déterminateur de signaux d'entrée (2) de l'ensemble d'amplificateurs (1),
- le déterminateur de signaux d'entrée (2) déterminant un premier signal d'entrée (s1) et un deuxième signal d'entrée (s2) à partir du signal initial (s),
- le déterminateur de signaux d'entrée (2) envoyant le premier signal d'entrée (s1) sur un premier amplificateur (3) qui amplifie le premier signal d'entrée (s1) pour donner un premier signal de sortie (S1),
- le déterminateur de signaux d'entrée (2) envoyant le deuxième signal d'entrée (s2) sur un deuxième amplificateur (4) qui amplifie le deuxième signal d'entrée (s2) pour donner un deuxième signal de sortie (S2),
- les signaux de sortie (S1, S2) présentant des amplitudes (A) identiques entre elles et la fréquence initiale (f), et leur décalage de phase (ϕ) l'un par rapport à l'autre, rapporté à la fréquence initiale (f), dépendant de la valeur absolue de l'amplitude (a) du signal initial (s),
- les amplificateurs (3, 4) envoyant leurs signaux de sortie (S1, S2) sur un élément de couplage commun (5) qui forme un signal utile (N) et un signal de perte (V) à partir des signaux de sortie (S1, S2),
- une puissance globale que présentent ensemble le signal utile (N) et le signal de perte (V) étant indépendante du décalage de phase (ϕ) des signaux de sortie (S1, S2), une puissance partielle du signal utile (N) étant maximale lorsque le décalage de phase (ϕ) des signaux de sortie (S1, S2) présente une valeur prédéfinie, et la puissance partielle du signal utile (N) décroissant avec l'écart du décalage de phase (ϕ) des signaux de sortie (S1, S2) par rapport à la valeur prédéfinie,
- l'élément de couplage (5) envoyant le signal utile (N) sur une charge (6) et le signal de perte (V) sur un dispositif redresseur (7),
- le dispositif redresseur (7) redressant le signal de perte (V) et envoyant le signal de perte redressé sur un dispositif d'alimentation électrique (8) de l'ensemble d'amplificateurs (1),
- des composants actifs (9) du dispositif redresseur (7) qui agissent en tant qu'éléments redresseurs (9) étant commandés de manière synchrone avec la fréquence initiale (f) et redressant ainsi le signal de perte (V).

6. Procédé d'exploitation selon la revendication 5, **caractérisé en ce que** le décalage de phase (ϕ) des signaux de sortie (S1, S2) est envoyé sur un dispositif de commande (10) pour le dispositif redresseur (7) et **en ce que** le dispositif de commande (10) tient compte du décalage de phase (ϕ) lors de la détermination de signaux de commande (c1, c2) pour les composants actifs (9).
